**Europäisches Patentamt**

**European Patent Office**

**Office européen des brevets**

(19)

(11) Veröffentlichungsnummer : **0 143 990
B1**

# EUROPÄISCHE PATENTSCHRIFT

(12)

(45) Veröffentlichungstag der Patentschrift :
**06.07.88**

(51) Int. Cl.⁴ : **G 01 R 31/28**

(21) Anmeldenummer : **84113098.2**

(22) Anmeldetag : **31.10.84**

(54) **Vorrichtung zum Prüfen und Sortieren von elektronischen Bauteilen, insbesondere von integrierten Chips.**

(30) Priorität : 07.11.83 DE 3340185

(43) Veröffentlichungstag der Anmeldung :
**12.06.85 Patentblatt 85/24**

(45) Bekanntmachung des Hinweises auf die Patenterteilung : **06.07.88 Patentblatt 88/27**

(84) Benannte Vertragsstaaten :
**AT BE CH DE FR GB IT LI LU NL SE**

(56) Entgegenhaltungen :
EP-A- 0 007 650
US-A- 3 662 881

(73) Patentinhaber : **Multitest Elektronische Systeme GmbH
Schullerstrasse 7
D-8200 Rosenheim (DE)**

(72) Erfinder : **Heigl, Helmut, Dr.
Anton-Fahrner-Strasse 1
D-8202 Kolbermoor (DE)**

(74) Vertreter : **Schmidt-Evers, Jürgen, Dipl.-Ing. et al
Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10
D-8000 München 22 (DE)**

EP 0 143 990 B1

**Beschreibung**

Die Erfindung betrifft eine Vorrichtung zum Prüfen und Sortieren von elektronischen Bauteilen, insbesondere von integrierten Chips, die mindestens zwei an gegenüberliegenden Stellen des Bauteiles etwa senkrecht über eine Seite des Bauteiles hinaustretende Anschlüsse aufweisen, mit einem Eingangsmagazin, das mindestens einen Aufnahmekanal zur Aufnahme der zu prüfenden Bauteile aufweist, mit einer Prüfeinrichtung, welcher die zu prüfenden Bauteile nacheinander zugeführt werden, und mit einem Ausgangsmagazin, das mehrere Aufnahmekanäle aufweist, in die die geprüften Bauteile einsortiert werden, wobei das Eingangs- und/oder das Ausgangsmagazin von einer Tragplatte mit parallel verlaufenden Nuten gebildet ist und zu jedem Aufnahmekanal zwei Nuten gehören, in denen die Anschlüsse der Bauteile geführt sind.

Bei einer bekannten Vorrichtung zum Prüfen und Sortieren von integrierten Chips (US-A-3 662 881) sind Magazine vorgesehen, die von einer Tragplatte gebildet sind, welche Paare von durch ein dünnes Stegteil getrennten Nuten aufweisen, wobei die Nutenpaare ihrerseits jeweils durch ein dickes Stegteil voneinander getrennt sind. Die dicken Stegteile sind höher als die dünnen Stegteile. Bei einer ersten Ausführungsform sind mehrere derartiger Platten aufeinanderliegend angeordnet, so daß Aufnahmekanäle bildende Hohlräume entstehen, die durch den Grund der Aufnahmenuten bzw. der Oberseite des schmalen Stegteiles und dem gegenüberliegend durch die Unterseite der aufliegenden Tragplatte begrenzt werden. Bei einer zweiten Ausführungsform weisen die dicken Stegteile in ihrem oberen Bereich Hinterschneidungen zur Führung der Chips auf. Beide Ausführungsformen sind zur Aufnahme von Chips nur einer Größe geeignet.

Bei einer anderen bekannten Vorrichtung zum Prüfen und Sortieren von integrierten Chips (EP-A1-0 007 650) ist ein Magazin vorgesehen, welches aus zwei durch ein Scharnier verbundenen Platten besteht, die aufeinander klappbar sind. Die eine Platte ist mit durch Stege getrennten Nuten versehen, wobei die Stege und die Nuten ein trapezförmiges Profil haben. Die Stege sind alle gleich hoch, und die Nuten sind alle gleich tief. Die andere Platte ist mit U-förmigen Profilschienen versehen, wobei beim Gegeneinanderklappen der beiden Platten jeder U-Schenkel mit Spiel in eine Nute der erstgenannten Platte eintaucht. Auf diese Weise werden Aufnahmekanäle für die Chips gebildet. Auch dieses Magazin ist jedoch nur zur Aufnahme von Chips einer bestimmten Größe geeignet.

Der Erfindung liegt die Aufgabe zugrunde, die Vorrichtung der eingangs beschriebenen Art dahingehend zu verbessern, daß das Eingangs- und/oder Ausgangsmagazin zwecks Vermeidung einer Umrüstung zur Aufnahme von Bauteilen unterschiedlicher Größe geeignet ist.

Die Aufgabe ist erfindungsgemäß dadurch gelöst, daß das betreffende Magazin neben der Führung der Bauteile-Anschlüsse in unmittelbar nebeneinander verlaufende Nuten auch deren Führung in nicht unmittelbar nebeneinander verlaufenden Nuten zuläßt.

Eine praktische Realisierungsmöglichkeit dieses Erfindungsgedankens kann darin bestehen, — wie an sich bekannt — auf der Tragplatte des betreffenden Magazins nebeneinander Paare von durch ein dünnes Stegteil getrennten Nuten vorgesehen sind, wobei die Nutenpaare ihrerseits jeweils durch ein dickeres Stegteil voneinander getrennt sind, und daß alle Stegteile gleiche Höhe haben. Insbesondere durch die letztgenannte Maßnahme wird gewährleistet, daß alle gewünschten Nuten-Kombinationen zur Führung der Bauteil-Anschlüsse verwendet werden können, da die Bauteile mit der zwischen den Anschlüssen liegenden Seite auf jedem der Stegteile gleiten können, ohne daß dies einen Unterschied hinsichtlich der Führung der Anschlüsse in den Nuten machen würde.

Eine besonders zweckmäßige Ausgestaltung der Erfindung kann ferner darin bestehen, daß für die Einführung der Bauteile in das betreffende Magazin gesonderte Einführungsmasken vorgesehen sind, deren Breiten dem Abstand der Anschlüsse unterschiedlich großer Bauteile entsprechen. Die Einführungsmasken verdecken jene Nuten, die nicht zur Führung von Bauteil-Anschlüssen dienen sollen und gewährleisten, daß die Bauteil-Anschlüsse in die nicht verdeckten Nuten einlaufen.

Dadurch, daß mindestens eines der Magazine zur Aufnahme von Bauteilen unterschiedlicher Größe geeignet ist, entfällt zumindest für dieses Magazin eine Umrüstung. Eine solche kann jedoch für die Prüfeinrichtung notwendig sein. Um die Umrüstzeit möglichst gering zu halten, wird in Weiterbildung der Erfindung vorgeschlagen, daß die Prüfeinrichtung zumindest bezüglich des Prüfbereiches auswechselbar ist, der an unterschiedliche Größen der Bauteile angepaßt sein muß.

Zweckmäßiger Weise weist die Prüfeinrichtung eine Bauteile-Wendeeinrichtung auf. Von dieser Maßnahme wird in vorteilhafter Weise dann Gebrauch gemacht, wenn die zu prüfenden Bauteile in derselben Lage aus der Vorrichtung austreten sollen, in der sie in die Vorrichtung eingeführt wurden. Dies ist z. B. dann der Fall, wenn sowohl ein Eingangsmagazin als auch ein Ausgangsmagazin verwendet werden soll und die zu prüfenden Bauteile auf einer bogenförmigen Bahn von einer Oberseite zu einer Unterseite geführt werden.

Anhand von Zeichnungen wird die Erfindung nachstehend an einem Ausführungsbeispiel näher erläutert.

Fig. 1 zeigt schematisch in verkleinertem Maßstab eine Seitenansicht einer zur Aufnahme und Prüfung von Bauteilen dienenden Maschine, bei der die Vorrichtung gemäß der Erfindung angewandt ist.

Fig. 2 zeigt in einer schematischen Stirnansicht das Profil eines bei der Maschine gemäß Fig. 1 verwendeten Eingangs- und/oder Ausgangsmagazins.

Fig. 3 zeigt in einem Ausschnitt eine Draufsicht auf das in Fig. 2 dargestellte Profil.

Fig. 4, 5 und 6 zeigen schematisch Einführungsmasken, die in Verbindung mit dem Profil gemäß Fig. 2 und 3 verwendbar sind.

Fig. 7 zeigt in einer vergrößerten Darstellung eine in der Maschine gemäß Fig. 1 verwendbare Prüfeinrichtung.

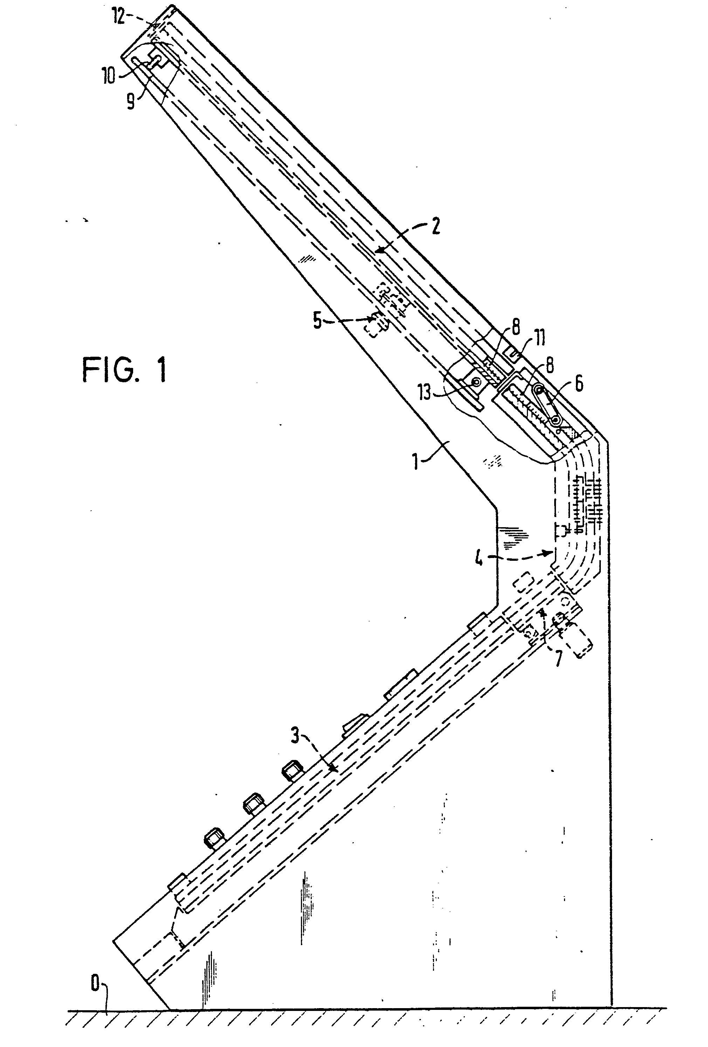

In Fig. 1 ist eine zur Aufnahme und Prüfung von Bauteilen dienende Maschine 1 schematisch dargestellt. Bei den betreffenden Bauteilen handelt es sich im vorliegenden Fall insbesondere um integrierte Chips 8, von denen in Fig. 1 einige angedeutet sind.

Die auf einem Boden O stehende Maschine 1 weist im oberen Bereich ein schräg stehendes Eingangsmagazin 2 und im unteren Bereich ein schräg stehendes Ausgangsmagazin 3 auf. Zwischen dem Eingangsmagazin 2 und dem Ausgangsmagazin 3 ist eine Prüfeinrichtung 4 enthalten, in der die von dem Eingangsmagazin 2 her abgegebenen einzelnen Bauteile 8 überprüft werden können und von der die jeweils überprüften Bauteile an das Ausgangsmagazin 3 abgegeben werden.

Das Eingangsmagazin 2 ist längs einer Tragstange 13 verschiebbar, die an einer Bodenplatte 9 angebracht ist. In Abstand von der Tragstange 13 weist das Eingangsmagazin 2 wenigstens eine Laufrolle 10 auf, mit der es auf der Bodenplatte 9 bei Verschiebung entlangzulaufen vermag.

Zum Verschieben des Eingangsmagazins 2 in Längsrichtung der Tragstange 13 dient eine Transporteinrichtung 5, die an der Bodenplatte 9 angebracht ist.

Im Eintrittsbereich der Prüfeinrichtung 4 ist in Fig. 1 eine Vereinzelungseinrichtung 6 angedeutet. Diese Vereinzelungseinrichtung 6 dient dazu, ihr von dem Eingangsmagazin 2 her zugeführte Bauteile 8 jeweils einzeln nacheinander in einen Prüf- bzw. Meßbereich der Prüfeinrichtung 4 weiterzuleiten. Im Bereich des Eingangsmagazins 2 können zweckmäßigerweise Einrichtungen vorgesehen sein, welche den betreffenden Bereich und damit die in diesem befindlichen Bauteile auf eine gewünschte Temperatur bringen. Normalerweise werden die betreffenden Einrichtungen Heizeinrichtungen sein.

Zwischen der Prüfeinrichtung 4 und dem Ausgangsmagazin 3 ist, wie dies Fig. 1 erkennen läßt, eine weitere Transporteinrichtung 7 vorgesehen. Die Aufgabe dieser Transporteinrichtung 7 besteht darin, ihr von der Prüfeinrichtung 4 her zugeführte Bauteile an das Ausgangsmagazin 3 weiterzuleiten.

Neben den zuvor betrachteten Elementen weist die in Fig. 1 schematisch dargestellte Maschine noch eine generell mit 11 bezeichnete ortsfeste Lichtschrankenanordnung im unteren Teil des Eingangsmagazins 2 und ebenfalls ortsfeste Anzeigeeinrichtungen 12 oberhalb des betreffenden Eingangsmagazins 2 auf. Mit Hilfe der Lichtschrankenanordnung 11 wird die Bewegung der einzelnen Bauteile 8 aus dem Eingangsmagazin 2 in die Prüfeinrichtung 4 ermittelt. Durch die Anzeigeeinrichtungen 12 erfolgt eine Anzeige bezüglich des Belegungszustands der einzelnen Aufnahmen des Eingangsmagazin 2 durch Bauteile 8.

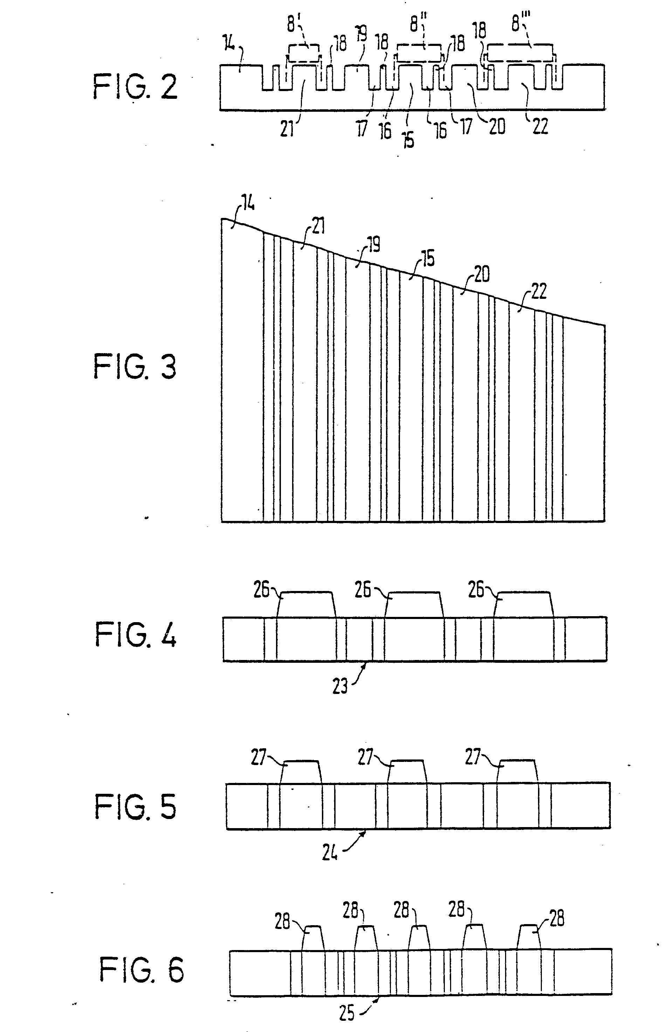

In Fig. 2 und 3 ist schematisch ein Profilteil 14 gezeigt, welches in dem Eingangsmagazin 2 und/ oder in dem Ausgangsmagazin 3 gemäß Fig. 1 für die Aufnahme von Bauteilen verwendet werden kann. Wie aus Fig. 2 deutlich hervorgeht, weist das durch eine Tragplatte gebildete Profilteil 14 eine Reihe von Bauteile-Aufnahmen auf, die mit 15, 19, 20, 21 bzw. 22 bezeichnet sind. Jede derartige Bauteil-Aufnahme ist durch ein Stegteil bestimmter Breite gegeben. Zu beiden Seiten jedes derartigen Stegteiles sind zwei gesonderte Nuten 16, 17 vorgesehen, wie dies bezüglich des Stegteiles 15 näher veranschaulicht ist. Die auf der jeweiligen Seite liegenden beiden Nuten sind durch einen Steg 18 voneinander getrennt. Die Anordnung ist dabei im übrigen so getroffen, daß die Nuten 16, 17 in bezug auf das jeweilige Stegteil, wie das Stegteil 16, symmetrisch ausgebildet sind.

Bei dem in Fig. 2 dargestellten Profilteil sind die zu beiden Seiten der Stegteile 15, 19, 20 vorgesehenen Nuten 16, 17 zugleich Nuten für das jeweils benachbarte Stegteil. So sind auf den einander zugewandten Seiten der beiden Stegteile 15 und 19 lediglich die beiden in Fig. 2 gezeigten Nuten 16, 17 vorgesehen, die durch ein dünnes Stegteil 18 voneinander getrennt sind.

Der Abstand zwischen den der jeweiligen Bauteile-Aufnahme zugehörigen Nuten 16, 17 ist dem Abstand der Bauteileanschlüsse von Bauteilen entsprechend gewählt, die in Fig. 2 mit 8', 8″ und 8‴ bezeichnet sind. Wie aus Fig. 2 zu ersehen ist, können durch die gewählte Konfiguration der Nuten 16, 17 Bauteile mit drei verschiedenen Abständen ihrer Bauteileanschlüsse verarbeitet werden.

In Fig. 4, 5 und 6 sind gesonderte Einführungsmasken 23, 24 bzw. 25 gezeigt, mit deren Hilfe die in Fig. 2 angedeuteten Bauteile 8', 8″ bzw. 8‴ in das jeweilige Magazin mit dem in Fig. 2 und 3 gezeigten Profilteil 14 einführbar sind. Die Einführungsmaske 23 weist von einer Tragplatte abstehende Stegteile 26 auf, die so bemessen sind, daß sie Bauteile entsprechend dem in Fig. 2 angedeuteten Bauteil 8‴ aufzunehmen vermögen. Die Einführungsmaske 24 weist von einer Tragplatte abstehende Stegteile 27 auf, die so bemessen sind, daß sie Bauteile entsprechend dem Bauteil 8″ gemäß Fig. 2 aufzunehmen vermögen. Die Einführungsmaske 25 weist schließlich von einer Tragplatte abstehende Stegteile 28 auf, die so bemessen sind, daß sie jeweils Bauteile entsprechend dem Bauteil 8' gemäß Fig. 2 aufzunehmen vermögen.

Die in Fig. 4 bis 6 gezeigten Einführungsmasken 23, 24, 25 werden zweckmäßigerweise als auswechselbare Einführungsmasken in Verbindung mit den jeweiligen Bauteilen verwendet.

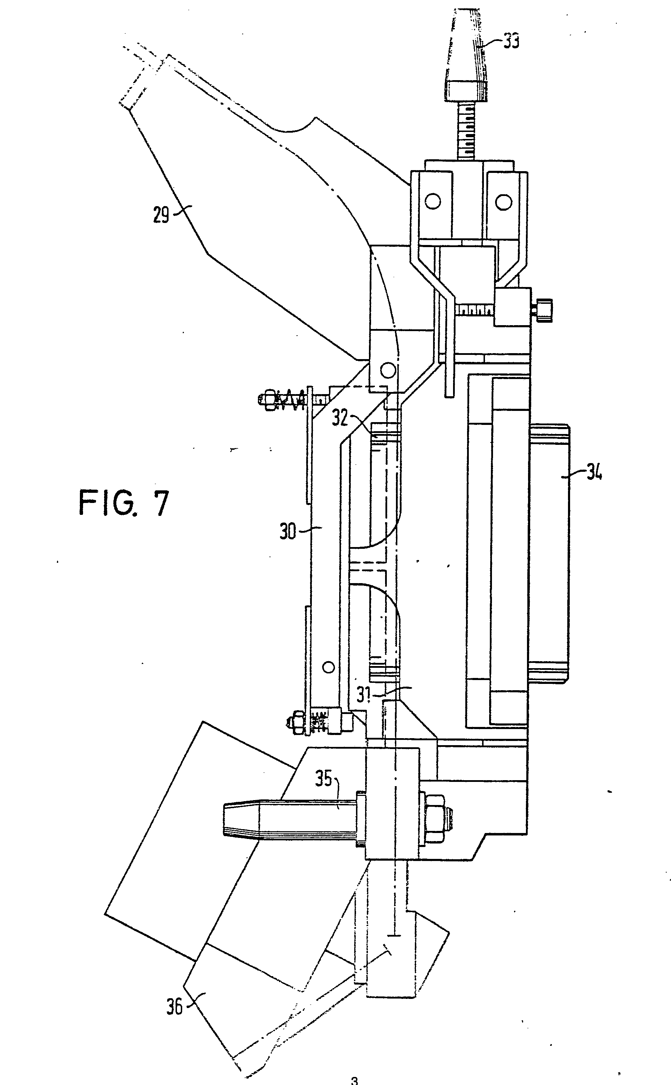

In Fig. 7 ist eine in der Maschine gemäß Fig. 1 verwendbare auswechselbare Prüfeinrichtung veranschaulicht. Die in Fig. 7 gezeigte Prüfeinrichtung umfaßt in ihrem oberen Bereich ein Kurventeil 29, welches die einzelnen von dem Eingangsmagazin 2 gemäß Fig. 1 abgegebenen Bauteile auf einer mit IC-Bahn bezeichneten Kurvenbahn aufzunehmen und in einen Meßbereich einzuführen gestattet. Dieser Meßbereich befindet sich im mittleren Teil der in Fig. 7 gezeigten Anordnung. In diesem Bereich wird das jeweilige Bauteil mittels einer Anpreßmechanik 30 in einer Meßposition festgehalten. Mittels einer Anpreßmechanik 31 für Kontaktfedern lassen sich Meßfühler an die elektrischen Anschlüsse des jeweiligen zu prüfenden Bauteiles andrücken.

In Fig. 7 sind Kontaktfedern 32 und 34 angedeutet, die mit Steckverbindern von Meß- bzw. Auswerteeinrichtungen verbunden sein können.

Im oberen Teil weist die in Fig. 7 dargestellte Anordnung eine Einstelleinrichtung 33 auf, mit der eine Höheneinstellung eines Stoppers in der betreffenden Prüfeinrichtung ermöglicht ist.

Im unteren Bereich zeigt die Fig. 7 einen Zentrierungsstift 35, der für die zentrierte Anbringung der betreffenden Prüfeinrichtung in der in Fig. 1 angedeuteten Maschine eine Rolle spielt.

Schließlich weist die in Fig. 7 dargestellte Prüfeinrichtung noch eine Bauteile-Wendeeinrichtung 36 auf, durch die sichergestellt ist, daß die betreffende Prüfeinrichtung verlassende Bauteile von dem in Fig. 1 angedeuteten Ausgangsmagazin 3 in der Weise aufgenommen werden können, wie dies anhand der Fig. 2 veranschaulicht worden ist.

Abschließend sei noch angemerkt, daß prinzipiell auch ohne eine Bauteile-Wendeeinrichtung in der Prüfeinrichtung ausgekommen werden kann, wenn das Eingangsmagazin und das Ausgangsmagazin der in Fig. 1 dargestellten Maschine praktisch in ein un derselben Ebene liegen.

**Patentansprüche**

1. Vorrichtung zum Prüfen und Sortieren von elektronischen Bauteilen (8′, 8″, 8‴), insbesondere von integrierten Chips, die mindestens zwei an gegenüberliegenden Seiten des Bauteils (8′, 8″, 8‴) etwa senkrecht über eine Seite des Bauteils (8′, 8″, 8‴) hinaustretende Anschlüsse aufweisen, mit einem Eingangsmagazin (2), das mindestens einen Aufnahmekanal zur Aufnahme der zu prüfenden Bauteile (8′, 8″, 8‴) aufweist, mit einer Prüfeinrichtung (4), welcher die zu prüfenden Bauteile (8′, 8″, 8‴) nacheinander zugeführt werden, und mit einem Ausgangsmagazin (3), das mehrere Aufnahmekanäle aufweist, in die die geprüften Bauteile (8′, 8″, 8‴) einsortiert werden, wobei das Eingangs- und/oder Ausgangsmagazin (2, 3) von einer Tragplatte (14) mit parallel verlaufenden Nuten (16, 17) gebildet ist und zu jedem Aufnahmekanal zwei Nuten (16, 17) gehören, in denen die Anschlüsse der Bauteile (8′, 8″, 8‴) geführt sind, dadurch gekennzeichnet, daß das betreffende Magazin (2, 3) zur Aufnahme von Bauteilen (8′, 8″, 8‴) unterschiedlicher Größe neben der Führung der Bauteil-Anschlüsse in unmittelbar nebeneinander verlaufenden Nuten (16, 17) auch deren Führung in nicht unmittelbar nebeneinander verlaufenden Nuten (16, 17) zuläßt.

2. Vorrichtung nach Anspruch 1, dadurch gekennzeichnet, daß auf der Tragplatte (14) des betreffenden Magazins (2, 3) nebeneinander Paare von durch ein dünnes Stegteil (18) getrennten Nuten (16, 17) vorgesehen sind, wobei die Nutenpaare (16, 17) ihrerseits jeweils durch ein dickeres Stegteil (15, 19, 20, 21) voneinander getrennt sind, und daß alle Stegteile (18, 15, 19, 20, 21) gleiche Höhe haben.

3. Vorrichtung nach Anspruch 1 oder 2, dadurch gekennzeichnet, daß für die Einführung der Bauteile (8′, 8″, 8‴) in das betreffende Magazin (2, 3) gesonderte Einführungsmasken (26, 27, 28) vorgesehen sind, deren Breiten dem Abstand der Anschlüsse unterschiedlich großer Bauteile (8′, 8″, 8‴) entsprechen.

4. Vorrichtung nach einem der Ansprüche 1 bis 3, dadurch gekennzeichnet, daß die Prüfeinrichtung (4) zumindest bezüglich des Prüfbereichs auswechselbar ist, der an unterschiedliche Größen der Bauteile (8′, 8″, 8‴) angepaßt sein muß.

5. Vorrichtung nach einem der Ansprüche 1 bis 4, dadurch gekennzeichnet, daß die Prüfeinrichtung (4) eine Bauteil-Wendeeinrichtung (36) aufweist.

**Claims**

1. A device for testing and sorting electronic components (8′, 8″, 8‴), in particular integrated chips which have at least two connections projecting more or less at right angles from one side of the component (8′, 8″, 8‴), having an input magazine (2) which has at least one receiving channel for receiving the component (8′, 8″, 8‴) to be tested, having a testing device (4) which is supplied with components (8′, 8″, 8‴) to be tested in succession, and having an output magazine (3) which has several receiving channels into which the tested components (8′, 8″, 8‴) are sorted, wherein the input and/or output magazine (2, 3) is formed by a supporting plate (14) having parallel grooves (16, 17) and each receiving channel has two grooves (16, 17) in which the connections of the components (8′, 8″, 8‴) are guided, characterised in that the magazine (2, 3) concerned, for receiving components (8′, 8″, 8‴) of different sizes, besides guiding the component-connections in grooves (16, 17) running directly next to one another, also allows them to be guided in grooves (16, 17) not running directly next to one another.

2. A device according to claim 1, characterised in that provided on the supporting plate (14) of the magazine (2, 3) concerned are pairs of grooves (16, 17) next to one another separated by a thin rib section (18), the pairs of grooves (16, 17) being separated from one another by a wider rib section (15, 19, 20, 21); and that all the rib sections (18, 15, 19, 20, 21), have the same height.

3. A device according to claim 1 or claim 2, characterised in that for the insertion of the components (8', 8", 8"') in to the magazine (2, 3) concerned, separate insertion masks (26, 27, 28) are provided which have a width which corresponds to the distance apart of the connections of components (8', 8", 8"') of different sizes.

4. A device according to any one of claims 1 to 3, characterised in that the testing device (4) is interchangeable at least in respect of the testing region which must match the different sizes of the components (8', 8", 8"').

5. A device according to any one of claims 1 to 4, characterised in that the testing device (4) has a component turning device (36).

**Revendications**

1. Dispositif pour tester et trier des composants électroniques (8', 8", 8"'), en particulier des chips intégrés, qui comportent au moins deux sorties qui sortent sur des côtés opposés du composant (8', 8", 8"') à peu près perpendiculairement à un côté du composant (8', 8", 8"'), comportant un magasin d'entrée (2) qui présente au moins un canal récepteur destiné à recevoir les composants (8', 8", 8"') à contrôler, un dispositif de contrôle (4) auquel les composants (8', 8", 8"') à contrôler sont amenés l'un après l'autre, et un magasin de sortie (3) qui présente plusieurs canaux récepteurs dans lesquels les composants (8', 8", 8"') contrôlés sont classés, le magasin d'entrée (2) et/ou le magasin de sortie (3) étant formé(s) d'une plaque support (14) pourvue de rainures parallèles (16, 17), et chaque canal récepteur comportant deux rainures (16, 17) dans lesquelles sont guidées les sorties des composants (8', 8", 8"'), caractérisé en ce que le magasin concerné (2, 3), pour la réception de composants (8', 8", 8"') de taille différente, permet, outre le guidage des sorties des composants dans des rainures (16, 17) immédiatement voisines, le guidage de celles-ci dans des rainures (16, 17) non immédiatement voisines.

2. Dispositif selon la revendication 1, caractérisé en ce que sur la plaque support (14) du magasin concerné (2, 3) sont prévues les unes à côté des autres des paires de rainures (16, 17) séparées par une nervure mince (18), les paires de rainures (16, 17) étant pour leur part séparées l'une de l'autre par une nervure plus épaisse (15, 19, 20, 21), et en ce que toutes les nervures (18, 15, 19, 20, 21) ont la même hauteur.

3. Dispositif selon l'une des revendications 1 ou 2, caractérisé en ce que pour l'entrée des composants (8', 8", 8"') dans le magasin concerné (2, 3) sont prévus des masques d'entrée distincts (26, 27, 28) dont la largeur correspond à la distance des sorties de composants (8', 8", 8"') de taille différente.

4. Dispositif selon l'une des revendications 1 à 3, caractérisé en ce que le dispositif de contrôle (4) peut être changé au moins en ce qui concerne la zone de contrôle qui doit être adaptée à la taille des composants (8', 8", 8"').

5. Dispositif selon l'une des revendications 1 à 4, caractérisé en ce que le dispositif de contrôle (4) comporte un dispositif (36) de retournement des composants.

FIG. 1

FIG. 2

FIG. 3

FIG. 4

FIG. 5

FIG. 6

# FIG. 7